# EUROPEAN PATENT SPECIFICATION

(11) **EP 0 450 389 B1**
(45) Date of publication and mention of the grant of the patent: **13.09.1995**
(21) Application number: 91104217.4
(22) Date of filing: 19.03.1991
(51) Int. Cl.: G11C 17/12, H01L 27/112

(54) **A low-capacitance, high breakdown voltage programmed cell structure for read-only memory circuits**
Zellstruktur mit niedriger Kapazität und mit hoher Durchbruchspannung programmiert für Festwertspeicherschaltungen
Structure de cellule à basse capacité et programmée à haute tension de claquage pour circuits de mémoires mortes

(30) Priority: 30.03.1990 IT 1990390
(43) Date of publication of application: 09.10.1991
(73) Proprietor: SGS-THOMSON MICROELECTRONICS s.r.l., 20041 Agrate Brianza (Milano) (IT)
(72) Inventor: Ginami, Giancarlo, I-24100 Bergamo (IT); Laurin, Enrico, I-20052 Monza-Milano (IT); Lucherini, Silvia, I-20144 Milano (IT); Vajana, Bruno, I-24100 Bergamo (IT)
(74) Representative: Perani, Aurelio

(56) References cited:
- EP-A- 0 073 130
- US-A- 4 268 950
- US-A- 4 359 817

## Description

This invention relates to a low-capacitance, high breakdown voltage programmed cell for read-only memory circuits, being of the type which comprises a field-effect transistor having conventional source and drain regions separated by a channel region overlaid by the transistor gate.

It is a known fact that read-only circuir structures or ROMs (Read Only Memories) are basically comprised of regular cell arrays.

The memory is programmed, in general, by making some predetermined cells non-conductive, thereby logic signals are output which are tied to the value of the input signals in a sought relationship.

Each cell basically comprises a transistor operating on a gate voltage Vg of 5 Volts. That is, all the gates of the cells in the array are connected to a common 5-Volt power source.

Between a programmed cell and a non-programmed one, there should be a current difference of some hundreds microamperes to permit of discrimination therebetween during the read-out stage.

In order to obtain a large difference between such currents, the prior art has commonly proposed of raising the conduction threshold of the corresponding transistors to the cells to be programmed. This can be achieved by increasing the surface concentration of dopant in the transistor channel region, e.g. by the additional implantation of type "p" impurities with boron ions.

However, the high surface concentration of the channel region and high doping of the adjacent drain region of the transistor cause the drain depletion zone to become small, which results in the drain capacitance becoming relatively high while the breakdown voltage is comparatively low.

In view of that the drain electrodes form the so-called bit line of a ROM, this bit line will exhibit a long charge time reflecting in a long access time to the memory.

The underlying technical problem of this invention is to provide a programmed cell structure for read-only memory circuits which has such structural and functional features as to enable the conduction threshold of to-be-programmed cells to be raised while keeping substantially unaltered the access time to the memory and, therefore, overcoming the mentioned drawback with which the prior art is beset.

This problem is solved by a cell structure as indicated being characterized in that it comprises a channel implant extending for predetermined distance only from the source region.

In a preferred embodiment, this distance is at least 10% of the distance separating the source region from the drain region.

The features and advantages of a cell structure according to the invention will become apparent from the following detailed description of an embodiment thereof, given by way of illustration and not of limitation with reference to the accompanying drawings.

In the drawings:
Figure 1 is a vertical section view showing schematically a cell structure according to the invention;
Figure 2 is a further schematic representation of the cell structure shown in Figure 1; and
Figures 3, 4 and 5 are comparative graphs showing respectively the characteristics of a cell structure according to the invention and cells according to the prior art.

With reference to the drawing figures, schematically shown at 1, in vertical section, is the construction of an elemental cell of a semiconductor integrated circuit, such as a read-only memory or ROM.

The cell 1 is basically comprised of a field-effect transistor 2, e.g. formed by MOS technology on a semiconductor silicon substrate 3.

Orderly sets of transistors 2, formed on the substrate 3, constitute the circuit layout of said memories.

Each transistor 2 comprises an active area 4 having oppositely located source and drain regions 5 and 6 separated by a so-called channel region 9.

Such regions are defined by altering the structure of the substrate 3 through controlled implanted amounts of doping ions.

Each source 5 and drain 6 region is split into a portion 8 having a lower dopant concentration, e.g. of the n- type, in the proximities of the channel region 9, and a portion 10 having a higher concentration of n+ dopant.

Over the region 9, there is grown a thin layer 10 of silicon dioxide onto which a layer 13 of polycrystalline silicon is deposited to define the gate 11 of transistor 2.

Advantageously, according to the invention, the cell 1 also comprises a so-called channel implant 12 which only extends by a predetermined distance from the source region 5.

In a preferred embodiment, this distance is adjusted according to the distance between the source region 5 and the drain region 6 and is at least 10% thereof.

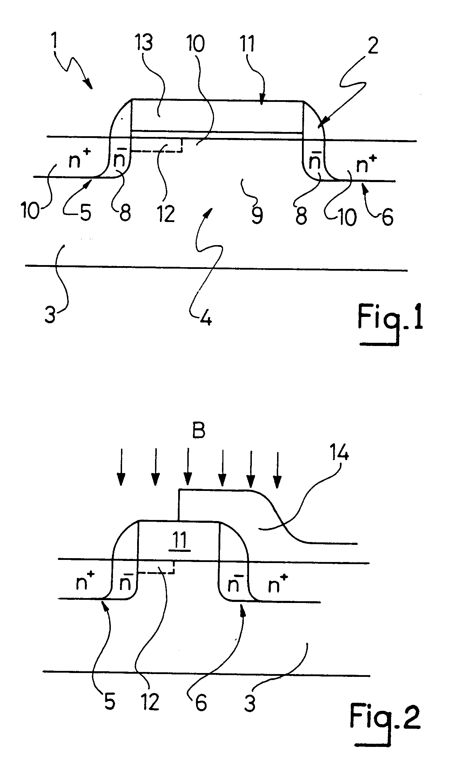

In essence, in the programmed cell 1, the channel implant 12 is only effected on the source side, not on the drain side, as clearly brought out by Figure 1.

The region 12 is provided by implantation of boron ions.

The technological process resulting in the formation of the cell 1 according to the invention merely involves partial masking of the gate 11 of transistor 2 during the implanting step for the region 12.

As shown in Figure 2, a masking out 14 of the drain region 6 and part of the gate 11 will provide, at the boron ion implanting stage, a channel implant 12 which extends from the source 5 over just a section of the channel region 9.

In other words, the programming mask 14 only leaves exposed part of the channel region 9 of the cells 1 to be programmed.

Actual tests carried out at the Applicant's premises have demonstrated that the electric performance of the inventive cell 1 is different from that of prior art cells as regards such parameters as threshold, sub-threshold, breakdown voltage, and drain capacitance.

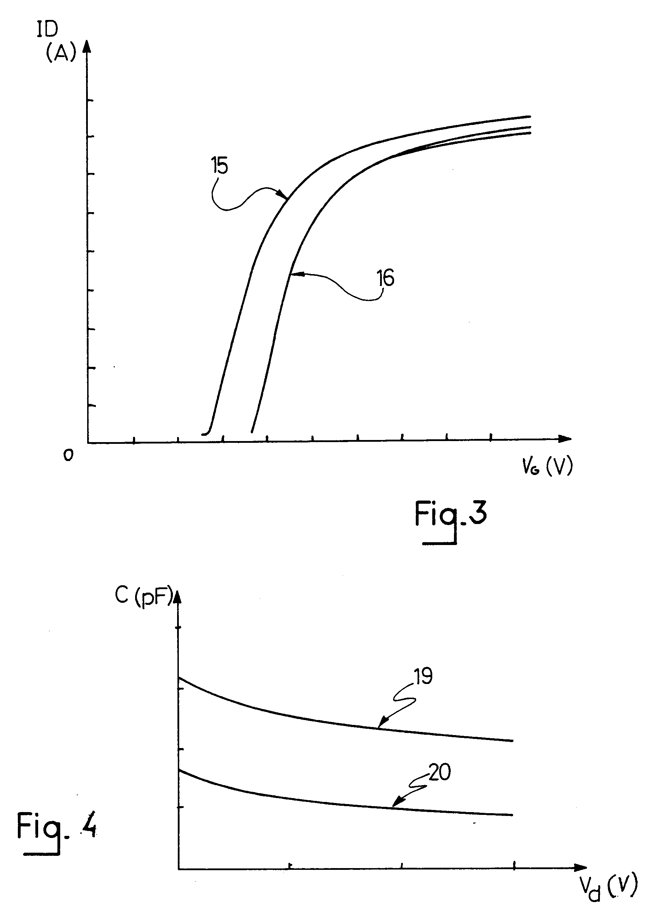

Annexed to this Application for demonstrative purposes are Figures 3 and 4, the former showing, with the curves 15 and 16, the values of the threshold voltage Vg plotted versus the drain current, for the cell 1 of this invention and cells made in accordance with the prior art.

In addition, the cell 1 of this invention has a breakdown voltage Vb which is definitely higher than that of conventional cells.

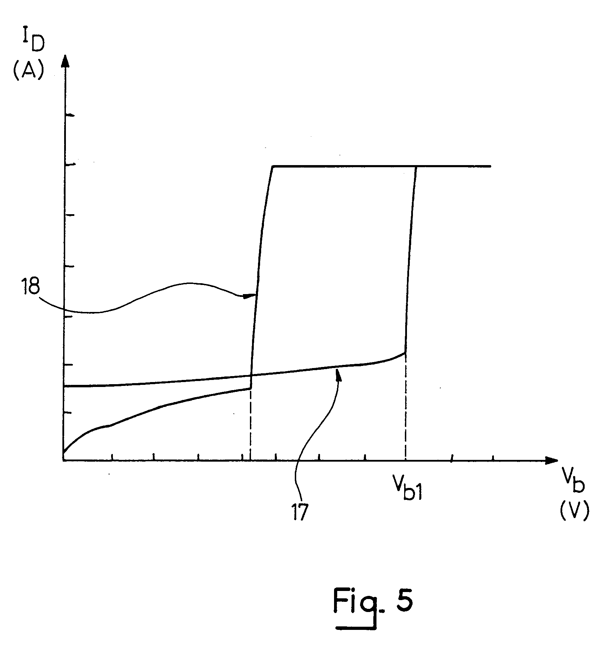

In this respect, it may be appreciated from Figure 5 that the Vb value for the cell 1 is about 16 Volts (curve 17) as against the 9 Volts of conventional cells (curve 18).

Compared in Figure 3 through the curves 19 and 20 is instead the capacitance C of the so-called bit line of a ROM comprising programmed cells of conventional design with that of cells made in accordance with this invention.

The threshold of the transistor 2 shows to be on the average .5-1 Volt lower than that of transistors according to the prior art, and this difference is not a significant one because, by appropriate adjustment of the dopant concentration, the threshold voltage can be kept above 5 Volts at all times.

## Claims

1. A low-capacitance, high breakdown voltage programmed cell structure (1) for read-only memory circuits, being of the type which comprises a field-effect transistor (2) having conventional source (5) and drain (6) regions separated by a channel region (9) overlaid by the transistor gate (11), characterized in that it comprises a channel implant (12) extending for a predetermined distance only from the source region (5).

2. A cell structure according to Claim 1, characterized in that said distance is at least 10% of the distance between the source region (5) and the drain region (6).

## Patentansprüche

1. Eine programmierte Zellenstruktur (1) mit geringer Kapazität und hoher Durchbruchspannung für Nur-Lese-Speicherschaltungen des Typs, der einen Feldeffekt-Transistor (2) mit einer herkömmlichen Source-Region (5) und Drain-Region (6), die durch eine Kanalregion (9) getrennt sind, über der das Transistorgate (11) liegt, aufweist, dadurch gekennzeichnet, daß dieselbe eine Kanalimplantation (12) aufweist, die sich nur von der Source-Region (5) um einen vorbestimmten Abstand erstreckt.

2. Eine Zellenstruktur gemäß Anspruch 1, dadurch gekennzeichnet, daß der Abstand mindestens 10% des Abstands zwischen der Source-Region (5) und der Drain-Region (6) beträgt.

## Revendications

1. Structure (1) de cellule programmée à faible capacité, haute tension de claquage pour circuits de mémoires mortes, du type qui comporte un transistor (2) à effet de champ ayant des régions classiques de source (5) et de drain (6) séparées par une région (9) de canal recouverte par la grille (11) du transistor, caractérisée en ce qu'elle comporte un implant (12) de canal s'étendant sur une distance prédéterminée uniquement à partir de la région de source (5).

2. Structure de cellule selon la revendication 1, caractérisée en ce que ladite distance est égale à au moins 10 % de la distance comprise entre la région de source (5) et la région de drain (6).
